# EUROPEAN PATENT APPLICATION

(11) **EP 4 839 062 A2**
(43) Date of publication of application: **11.11.2026**
(21) Application number: 26207640.9
(22) Date of filing: 28.03.2025
(51) Int. Cl.: H10F 77/70

(54) **SEGMENTED SOLAR CELL, METHOD FOR FORMING THE SAME AND PHOTOVOLTAIC MODULE**

(30) Priority: 09.04.2024 CN 202410424836
(62) Document number(s) of the earlier application(s) in accordance with Art. 76 EPC: 25167003.0 / 4 633 329
(71) Applicant: Zhejiang Jinko Solar Co., Ltd., Haining, Zhejiang 314416 (CN)
(72) Inventor: LIAO, Guangming, Haining, Zhejiang 314416 (CN); CUI, Wei, Haining, Zhejiang 314416 (CN); ZHANG, Bike, Haining, Zhejiang 314416 (CN); JIN, Jingsheng, Haining, Zhejiang 314416 (CN)
(74) Representative: Balder IP Law, S.L.

(57) **Abstract**

The present disclosure relates to the technical field of photovoltaics, and in particular, to a segmented solar cell (100), a method for forming the same, and a photovoltaic module. The segmented solar cell (100) is formed by cutting a solar cell, and the segmented solar cell (100) includes a substrate (11) and a cutting surface (110) formed by cutting a solar cell to form the segmented solar cell (100). The cutting surface (110) exposes a cross section of the substrate (11). At least part of the cutting surface (110) includes a first texture structure, the first texture structure includes polygonal portions (111), and at least one polygonal portion of the polygonal portions (111) partially overlaps with at least one neighboring polygonal portion of the polygonal portions (111). According to the present disclosure, it is conducive to at least improving performance of the segmented solar cell (100) and the photovoltaic module.

## Description

### TECHNICAL FIELD

The present disclosure relates to the technical field of photovoltaics, and in particular, to a segmented solar cell, a method for forming a segmented solar cell and a photovoltaic module.

### BACKGROUND

With continuous development and application of a photovoltaic power generation technology, methods for forming photovoltaic cells and structures of the photovoltaic cells have received widespread attentions. As an output current of a photovoltaic module formed after encapsulation of a photovoltaic cell continues to increase, internal loss of the photovoltaic module has an increasing impact. In order to reduce the internal loss of the photovoltaic module and increase output power of the photovoltaic module, currently, the photovoltaic cell is generally cut into segmented solar cells and then encapsulated, to reduce currents of the photovoltaic cells collected in series, thereby reducing the internal loss of the photovoltaic module.

However, currently, steps of cutting the photovoltaic cell may cause damage to the segmented solar cells and reduce performance of the segmented solar cells.

### SUMMARY

Some embodiments of the present disclosure provide a segmented solar cell, a method for forming the same and a photovoltaic module, which helps at least to improve performance of the segmented solar cell and the photovoltaic module.

Some embodiments of the present disclosure provide a segmented solar cell. The segmented solar cell comprises a substrate and a cutting surface formed by cutting a solar cell. The cutting surface exposes a cross section of the substrate. At least part of the cutting surface includes a first texture structure, the first texture structure includes polygonal portions, and at least one polygonal portion of the polygonal portions partially overlaps with at least one neighboring polygonal portion of the polygonal portions.

In some embodiments of the present disclosure, the polygonal portions are recessed towards the segmented solar cell.

In some embodiments of the present disclosure, a depth of at least some of the polygonal portions recessed towards the segmented solar cell ranges from 10 nm to 500 nm.

In some embodiments of the present disclosure, a bottom surface of at least one of the polygonal portions is a planar surface.

In some embodiments of the present disclosure, an angle formed between the bottom surface of at least one of the polygonal portions and the cutting surface is less than 30°.

In some embodiments of the present disclosure, along a direction perpendicular to the cutting surface, a height difference is formed between the bottom surfaces of two polygonal portions that overlap with each other.

In some embodiments of the present disclosure, along the direction perpendicular to the cutting surface, the height difference formed between the bottom surfaces of the two polygonal portions that overlap with each other is within a range from 10 nm to 500 nm.

In some embodiments of the present disclosure, any of the polygonal portions is adjacent to at least one of the polygonal portions, and any of the polygonal portions partially overlaps with at least one neighboring polygonal portion of the polygonal portions.

In some embodiments of the present disclosure, the polygonal portions are preferably rectangular potions, the rectangular portions each include a long side and a wide side, a size of the long side is defined as a first size, a size of the wide side is defined as a second size, a product of the first size and the second size is defined as a first value, and for any of the rectangular portions, a ratio of an area value of the bottom surface of the rectangular portion to the first value is within a range from 10% to 90%.

In some embodiments of the present disclosure, a density of the polygonal portions located at the cutting surface is within a range from 10³ to 10⁵ /mm².

In some embodiments of the present disclosure, the polygonal portions are preferably rectangular potions, the rectangular portions each include a long side and a wide side; and along an extension direction of the long side, a size of the long side is within a range from 3 µm to 15 µm, and/or along an extension direction of the wide side, a size of the wide side is within a range from 3 µm to 15 µm.

Correspondingly, some embodiments of the present disclosure further provide a method for forming a segmented solar cell, including: providing a solar cell; and cutting the solar cell to form the segmented solar cell, the segmented solar cell including a substrate and a cutting surface formed by the cutting. At least part of the cutting surface includes a first texture structure, the first texture structure includes polygonal portions, and at least one polygonal portion of the polygonal portions partially overlaps with at least one neighboring polygonal portion of the polygonal portions.

In some embodiments of the present disclosure, the cutting includes: laser-grooving the solar cell by using a laser grooving process to form a groove at part of a surface of the solar cell, and for the laser grooving process, a laser wavelength is within a range from 500 nm to 1000 nm, a laser pulse width is within a range from 10 ns to 1000 ns, and laser power is within a range from 50 W to 100 W.

In some embodiments of the present disclosure, the cutting further includes: heating the groove by using a laser heating process, and for the laser heating process, a laser wavelength is within a range from 500 nm to 1000 nm, a laser pulse width is within a range from 10 ns to 1000 ns, and laser power is within a range from 20 W to 50 W.

Correspondingly, some embodiments of the present disclosure further provide a photovoltaic module, including: a solar cell string including the segmented solar cell as described in any one of above-mentioned embodiments; an encapsulation adhesive film configured to cover a surface of the solar cell string; and a cover plate configured to cover a surface of the encapsulation adhesive film away from the solar cell string.

The technical solutions provided in the embodiments of the present disclosure achieve at least the following advantages. In the technical solutions provided in the embodiments of the present disclosure, a segmented solar cell includes a substrate and a cutting surface formed by cutting a solar cell. The cutting surface exposes a cross section of the substrate. At least part of the cutting surface includes a first texture structure, the first texture structure includes a plurality of polygonal portions, and the plurality of polygonal portions enable the segmented solar cell to have a lower surface-to-plane ratio, which can effectively reduce the density of dangling bonds at the cutting surface and help to reduce a recombination current at an edge of the segmented solar cell, thereby improving performance of the segmented solar cell.

### BRIEF DESCRIPTION OF DRAWINGS

One or more embodiments are exemplarily described with reference to the corresponding figures in the accompanying drawings, and the exemplary descriptions are not to be construed as limiting the embodiments. Elements with the same reference numerals in the accompanying drawings are represented as similar elements. Unless otherwise particularly stated, the figures in the accompanying drawings are not drawn to scale.
FIG. 1 is a schematic structural diagram of a segmented solar cell according to the related art;
FIG. 2 is a scanning electron microscope diagram of a partial cutting surface of a segmented solar cell according to some embodiments of the present disclosure;
FIG. 3 is a schematic structural diagram of a segmented solar cell according to some embodiments of the present disclosure;
FIG. 4 is a schematic diagram of an enlarged structure of the partial cutting surface within the dotted line frame in FIG. 2;
FIG. 5 is a schematic diagram of a partial structure of a segmented solar cell according to some embodiments of the present disclosure; and
FIG. 6 is a schematic diagram of a partial structure of another segmented solar cell according to some embodiments of the present disclosure.

### DESCRIPTION OF EMBODIMENTS

As can be seen from the Background, cutting may degrade performance of the segmented solar cell.

After analysis, it is found that lots of module technologies have emerged currently in order to improve the energy density of the photovoltaic module. Half-cell technology, and shingled array module (SAM) technology are representative technologies. These technologies are characterized by cutting a photovoltaic cell into half cells, one-third cells, or smaller segmented solar cells to fill a module with as many segmented solar cells as possible to increase an effective power generation area. At the same time, since a current of the segmented solar cell is reduced, power loss is reduced, which helps to comprehensively improve the module power.

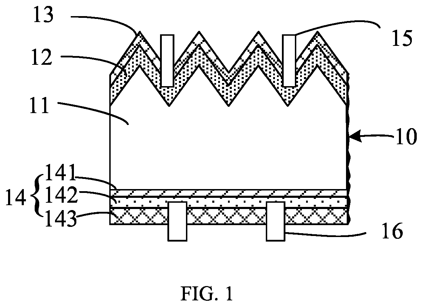

FIG. 1 is a schematic structural diagram of a segmented solar cell according to the related art.

However, cutting a photovoltaic cell may cause certain efficiency loss, mainly including the following two types. One type is mechanical loss. For example, after a laser damage region is melted, silicon atoms in a region where silicon recrystallizes lose an orderly arrangement. The other type is that a large number of dangling bonds may be formed at a surface of a breaking part, forming an electron-hole recombination center. For example, the segmented solar cell is a cut tunnel oxide passivated contact (TOPCon) solar cell. Referring to FIG. 1, a region exposed at a cutting surface 10 includes an emitter 12 and a silicon substrate 11. From the perspective of carrier recombination, cutting increases p-n junction region recombination and base region recombination.

In order to solve the above-mentioned problems, some embodiments of the present disclosure provide a segmented solar cell. A cutting surface of the segmented solar cell includes a first texture structure, the first texture structure includes a plurality of polygonal portions, and the polygonal portions make the cutting surface of the segmented solar cell to have a smaller surface area and enable the segmented solar cell to have a lower surface-to-plane ratio (i.e., a ratio of a surface area to a plane area), which can effectively reduce the density of dangling bonds at the cutting surface and help to reduce a recombination current at an edge of the segmented solar cell, thereby improving performance of the segmented solar cell. The polygonal portions are preferably rectangular portions. In the following description, the polygonal portions are implemented as rectangular portions by way of example.

Embodiments of the present disclosure will be described in detail below with reference to the accompanying drawings. However, those of ordinary skill in the art may understand that in the embodiments of the present disclosure, many technical details are provided to enable readers to better understand the embodiments of the present disclosure. However, even without these technical details and various changes and modifications based on the following embodiments, the technical solutions claimed in the embodiments of the present disclosure can still be implemented.

In the description of the embodiments of the present disclosure, the technical terms "first", "second", and the like are merely intended to distinguish different objects, and cannot be understood as an indication or implication of relative importance or implicit indication of the number, specific sequence, or dominant-subordinate relationship of the technical features indicated. In the description of the embodiments of the present disclosure, "multiple/a plurality of" means two or more, unless otherwise specifically stated.

The term "embodiment" described herein means that specific features, structures, or characteristics described in combination with the embodiments may be incorporated in at least one embodiment of the present disclosure. Phrases appearing at various positions of the specification refer to neither the same embodiment nor separate or alternative embodiments that are mutually exclusive with other embodiments. It is explicitly and implicitly understood by those skilled in the art that the embodiments described herein may be combined with other embodiments.

In the description of the embodiments of the present disclosure, the term "and/or" herein is merely an association relationship describing associated objects, indicating that three relationships may exist. For example, A and/or B indicates that there are three cases: A alone, A and B together, and B alone. In addition, the character "/" herein generally indicates an "or" relationship between the associated objects.

In the description of the embodiments of the present disclosure, the term "multiple/a plurality of" means two or more (including two). Similarly, "a plurality of groups" means two or more (including two) groups, and "a plurality of pieces" means two or more (including two) pieces.

In the description of the embodiments of the present disclosure, the orientation or position relationships indicated by the technical terms "thickness", "upper", "lower", and the like are based on the orientation or position relationships shown in the accompanying drawings and are intended to facilitate the description of the present disclosure and simplify the description only, rather than indicating or implying that the apparatus or element referred to must have a particular orientation or be constructed and operated in a particular orientation, and therefore are not to be interpreted as limiting the embodiments of the present disclosure.

In the drawings corresponding to the embodiments of the present disclosure, for a purpose of better illustration and description, a thickness and an area of a layer are exaggerated. When a component (such as a layer, film, region, or base) is described as being on another component or on a surface of another component, the component may be "directly" arranged on the surface of the another component or there may be a third component arranged between the two components. In contrast, when one component is described as being at the surface of another component or another component is formed at or provided at a surface of one component, there is no third component between the two components. In addition, when a component is described as being "substantially" formed on another component, it means that the component is neither formed on the entire surface (or a front surface) of the another component, nor formed on part of an edge of the entire surface.

In the description of the embodiments of the present disclosure, when a component "includes" another component, other components are not excluded and may further be included unless otherwise stated. In addition, when a component such as a layer, a film, a region, or a plate is referred to as being "on" another component, it may be "directly on" the another component (i.e., on a surface of the another component without other components therebetween), or another component may exist therebetween. In addition, when a component such as a layer, a film, a region, or a plate is "directly on" another component, or when a component such as a layer, a film, a region, or a plate is at a surface of another component, it means that no other component exists therebetween.

The terms used in the description of the embodiments herein are for describing particular embodiments only and not intended to provide a limitation. As used in the description of the embodiments described and in the appended claims, "component" is also intended to include a plural form unless the context clearly indicates otherwise. A component may include a component such as a layer, a film, a region, or a plate.

Some embodiments of the present disclosure provide a segmented solar cell. The segmented solar cell is formed by cutting a solar cell.

In some embodiments, the segmented solar cell may be any one of a passivated emitter and rear cell (PERC), a passivated emitter and rear totally-diffused cell (PERT), a tunnel oxide passivated contact (TOPCon) cell, a heterojunction technology (HIT/HJT) cell, or a back contact (BC) cell.

In some embodiments, the segmented solar cell may be a monocrystalline silicon photovoltaic cell, a polycrystalline silicon photovoltaic cell, an amorphous silicon photovoltaic cell, or a multi-compound photovoltaic cell. The multi-compound photovoltaic cell may be a cadmium sulfide photovoltaic cell, a gallium arsenide photovoltaic cell, a copper indium selenide photovoltaic cell, or a perovskite photovoltaic cell.

In some embodiments, as shown in Fig. 1, the segmented solar cell may include a first passivation layer 13, a substrate 11, and a second passivation layer 14 stacked in sequence. The substrate 11 includes a first surface and a second surface opposite to each other, the first passivation layer 13 may be located at the first surface of the substrate 11, and the second passivation layer 14 may be located at the second surface of the substrate 11. The segmented solar cell further includes a first electrode 15 and a second electrode 16, the first electrode 15 may pass through the first passivation layer 13 along a thickness direction of the first passivation layer 13 to contact the first surface of the substrate 11, and the second electrode 16 may pass through the second passivation layer 14 along a thickness direction of the second passivation layer 14 to contact the second surface of the substrate 11. The substrate 11 is configured to receive incident light and generate photogenerated carriers. The first electrode and the second electrode are configured to collect the photogenerated carriers. The first passivation layer 13 and the second passivation layer 14 can prevent oxidation or corrosion of the surface of the substrate, to improve stability and prolong the service life of the solar cell.

In some embodiments, the first electrode and the second electrode may both be located at the first surface of the substrate or both be located at the second surface of the substrate. That is, the segmented solar cell is a BC cell.

In some embodiments, a material of the substrate may be at least one of monocrystalline silicon, polycrystalline silicon, amorphous silicon, or microcrystalline silicon. In some embodiments, materials of the first passivation layer and the second passivation layer may each include one or more of silicon oxide, silicon nitride, silicon oxynitride, silicon oxycarbonitride, titanium oxide, hafnium oxide, or aluminum oxide.

In some embodiments, the substrate may be an N-type semiconductor substrate or a P-type semiconductor substrate. The N-type semiconductor substrate is doped with an N-type doping element. The N-type doping element may be any one of Group V elements such as a phosphorus (P) element, a bismuth (Bi) element, a stibium (Sb) element, and an arsenic (As) element. The P-type semiconductor substrate is doped with a P-type doping element. The P-type doping element may be any one of Group III elements such as a boron (B) element, an aluminum (Al) element, a gallium (Ga) element, and an indium (In) element.

The substrate may include an emitter 12, as shown in Fig. 1. In some embodiments, the emitter is located at a side of the substrate close to the first passivation layer and is in contact with the first passivation layer. A type of a doping element in the emitter is opposite to a type of a doping element in the substrate, thereby forming a PN junction with the substrate. For example, if the doping element in the substrate is a P-type doping element, the doping element in the emitter is an N-type doping element; and if the doping element in the substrate is an N-type doping element, the doping element in the emitter is a P-type doping element. The PN junction can receive incident light irradiating at the surface of the substrate and generate electron-hole pairs. For example, when the substrate is an N-type substrate, separated electrons move into the substrate, and separated holes move into the emitter, thereby forming a current.

In some embodiments, a textured surface structure may be formed at at least one side surface of the substrate, such as a pyramid-like textured surface structure. In this case, the textured surface structure can enhance absorption and utilization of incident light by the substrate, thereby helping to improve light conversion efficiency of the solar cell. If the photovoltaic cell is a single-side solar cell, a textured surface may be formed only at one side of the substrate, and another side of the substrate may have a polished surface. That is, the polished surface of the substrate is flatter than the textured surface. It is to be noted that for the single-side solar cell, the textured surface may be formed at each of the two sides of the substrate. If the photovoltaic cell is a double-side solar cell, the textured surface may be formed at each of two sides of the substrate.

In some embodiments, the material of the first passivation layer may include at least one of aluminum oxide, silicon oxide, silicon nitride, or silicon oxynitride. The first passivation layer may have a single-layer structure or a laminated structure. For example, the single-layer structure may be a single-layer aluminum oxide film, a single-layer silicon oxide film, a single-layer silicon nitride film, and a single-layer silicon oxynitride film; and the laminated structure may be formed by at least two layers of an aluminum oxide film, a silicon oxide film, a silicon nitride film, and a silicon nitride oxide film.

In some embodiments, the material of the second passivation layer may include at least one of aluminum oxide, silicon oxide, silicon nitride, and silicon oxynitride. The second passivation layer may have a single-layer structure or a laminated structure. For example, the single-layer structure may be a single-layer aluminum oxide film, a single-layer silicon oxide film, a single-layer silicon nitride film, or a single-layer silicon oxynitride film; and the laminated structure may be formed by at least two layers of an aluminum oxide film, a silicon oxide film, a silicon nitride film, and a silicon nitride oxide film.

In some embodiments, as shown in Fig. 1, the second passivation layer 14 may include a tunnel layer 141, a doped conductive layer 142, and an antireflection layer 143 sequentially stacked in a direction away from the surface of the substrate. The tunnel layer 141 and the doped conductive layer 142 are configured to form a passivation contact structure. The tunnel layer 141 can have a chemical passivation effect. Due to existence of interface state defects at the surface of the substrate, the tunnel layer can saturate dangling bonds at the surface of the substrate, reduce the defect state density at the surface of the substrate, and reduce recombination centers at the surface of the substrate to reduce a carrier recombination rate, so that the interface state density at the surface of the substrate is high, which facilitates recombination of the photogenerated carriers, and increase a filling factor, a short-circuit current, and an open-circuit voltage of the photovoltaic cell, to improve photoelectric conversion efficiency of the photovoltaic cell. The doped conductive layer 142 can have a field passivation effect, and the doped conductive layer 142 can form an electrostatic field, to allow minority carriers to escape from the interface and reduce concentration of the minority carriers, so that the carrier recombination rate at the interface of the substrate is low, thus increasing an open-circuit voltage, a short-circuit current, and a filling factor of the photovoltaic cell and improving the photoelectric conversion efficiency of the photovoltaic cell. The antireflection layer 143 can reduce reflectivity of sunlight at a surface of the photovoltaic cell, thereby allowing more light to be absorbed and converted into electrical energy, thus improving light absorption efficiency of the photovoltaic cell. Moreover, the antireflection layer can protect an internal structure of the solar cell, prevent pollution of the solar cell by the environment, and improve stability of the photovoltaic cell.

A material of the tunnel layer may include at least one of silicon oxide, silicon nitride, silicon nitride, silicon carbide, and magnesium fluoride.

A material of the doped conductive layer may be at least one of amorphous silicon, polycrystalline silicon, and silicon carbide. The doped conductive layer includes the same doping element as the substrate. If the type of the doping element in the substrate is P-type, the type of the doping element in the doped conductive layer is also P-type; and if the type of the doping element in the substrate is N-type, the type of the doping element in the doped conductive layer is also N-type.

A material of the antireflection layer may be one of silicon oxide, aluminum oxide, silicon nitride, and silicon oxynitride.

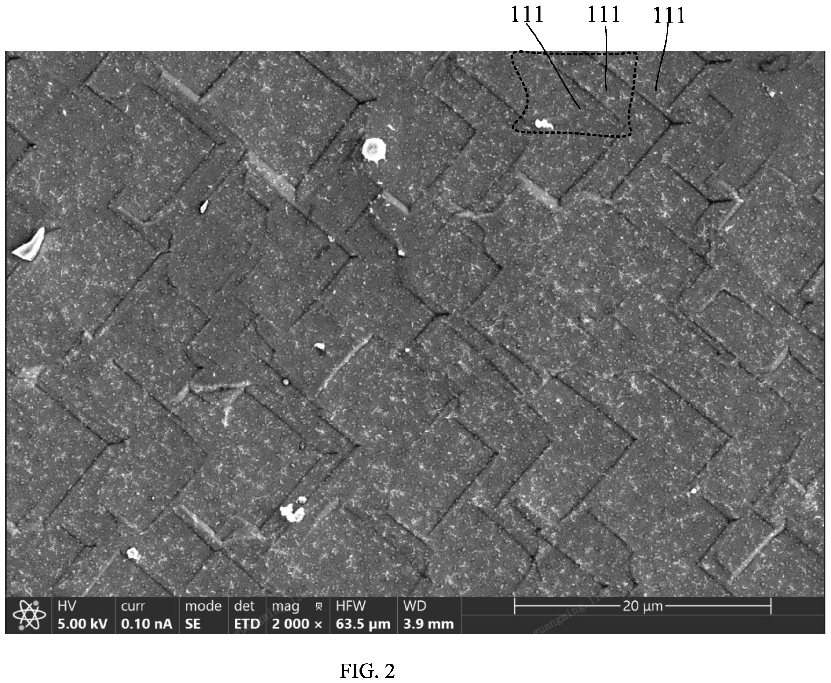

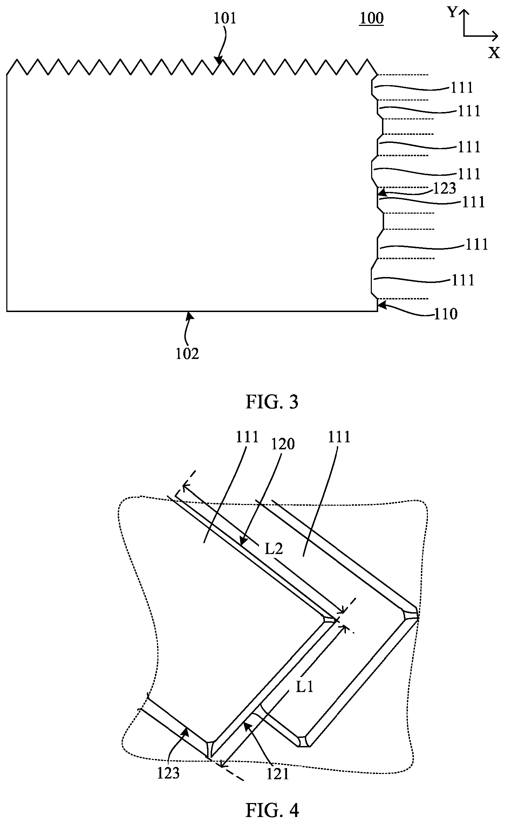

FIG. 2 is a scanning electron microscope diagram of a partial cutting surface of a segmented solar cell according to some embodiments of the present disclosure; FIG. 3 is a schematic structural diagram of a segmented solar cell according to some embodiments of the present disclosure; and FIG. 4 is a schematic diagram of an enlarged structure of the partial cutting surface within the dotted line frame in FIG. 2.

Referring to FIG. 2 to FIG. 4, the segmented solar cell 100 includes a cutting surface 110 formed by cutting a solar cell. At least part of the cutting surface 110 includes a first texture structure, the first texture structure includes a plurality of rectangular portions 111, and at least one rectangular portion 111 partially overlaps with at least one neighboring rectangular portion 111. Compared with a case where the cutting surface 110 includes more irregular protruding structures or concave structures, and the protruding structures protrude obviously and the concave structures are recessed deeply, in some embodiments of the present disclosure, the use of the rectangular portions 111 as the structures at the cutting surface 110 helps to reduce a surface-to-plane ratio of the segmented solar cell 100, that is, helps to improve flatness of the cutting surface 110 of the segmented solar cell 100 formed by cutting, so that the cutting surface 110 formed by cutting has a smaller surface area, thereby reducing dangling bonds and recombination centers at the surface of the cutting surface 110, helping to reduce a recombination current at an edge of the segmented solar cell 100, and improving performance of the segmented solar cell 100.

In some embodiments, an entire surface structure of the cutting surface 110 is the first texture structure.

It is to be noted that if the first texture structure at the cutting surface 110 occupies a larger area on the cutting surface 110, there is a greater number of rectangular portions 111 of the surface structure of the cutting surface 110. In other words, if all the rectangular portions 111 at the cutting surface 110 occupy a larger area of the cutting surface 110, there is less cutting damage to the cutting surface 110 formed by cutting, and the performance of the segmented solar cell 100 is better.

Referring to FIG. 3, the segmented solar cell 100 includes a first surface 101 and a second surface 102 arranged along a first direction Y and opposite to each other, and two sides of the cutting surface 110 along the first direction Y are connected to the first surface 101 and the second surface 102. It can be understood that the cutting surface 110 is actually not a completely flat planar surface, and a direction perpendicular to the cutting surface 110 as referred to in the embodiments of the present disclosure is a direction perpendicular to the cutting surface 110 when the cutting surface 110 is approximated as a flat plane perpendicular to the first surface 101 (or perpendicular to the second surface 102). In other words, the direction perpendicular to the cutting surface 110 is a second direction X referred to in the relevant drawings.

It is to be noted that if a rectangular portion 111 overlaps with another neighboring rectangular portion 111, then along the second direction X, an orthographic projection of the rectangular portion 111 onto the cutting surface 110 is not a complete rectangle. That is, if one rectangular portion 111 does not overlap with any rectangular portion 111, then an orthographic projection of the rectangular portion 111 onto the cutting surface 110 is a rectangle, a quadrilateral, or an approximate rectangle. Herein, the approximate rectangle refers to a rectangle with small imperfections or small irregularities at edges.

Referring to FIG. 2 and FIG. 3, a plurality of rectangular portions 111 in the first texture structure are arranged along a direction parallel to the cutting surface 110. The direction parallel to the cutting surface 110 as referred to in the embodiments of the present disclosure is a direction parallel to the cutting surface 110 when the cutting surface 110 is approximated as a flat plane perpendicular to the first surface 101 (or perpendicular to the second surface 102).

In some embodiments, any rectangular portion 111 is adjacent to at least one rectangular portion 111, and any rectangular portion 111 partially overlaps with at least one neighboring rectangular portion 111. That is, for a plurality of rectangular portions 111 in the first texture structure, each rectangular portion 111 overlaps with another neighboring rectangular portion 111, and an orthographic projection of any rectangular portion 111 in the first texture structure onto the cutting surface 110 is an incomplete rectangle.

In some embodiments, the rectangular portion 111 is recessed towards the segmented solar cell 100. That is, any rectangular portion 111 may be a recessed structure that is recessed towards the segmented solar cell 100.

In some embodiments, referring to FIG. 3 and FIG. 4, a bottom surface 123 of any rectangular portion 111 is a planar surface. The planar surface has a smaller surface area than a concave or convex surface. Therefore, the rectangular portion 111 serves as a surface structure of the cutting surface 110, which helps to reduce the surface-to-plane ratio of the segmented solar cell 100 obtained by cutting, thereby helping to reduce dangling bonds and recombination centers at the surface of the cutting surface 110, helping to reduce a recombination current at an edge of the segmented solar cell 100, and improving performance of the segmented solar cell 100.

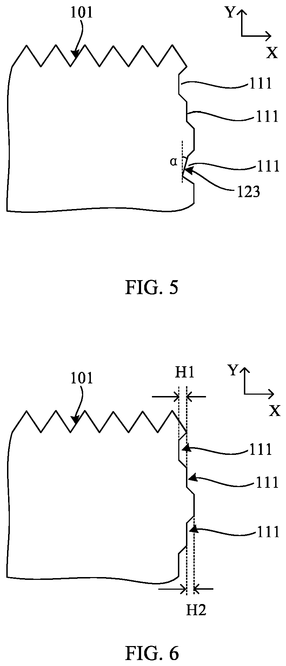

FIG. 5 is a schematic diagram of a partial structure of a segmented solar cell according to some embodiments of the present disclosure.

In some embodiments, referring to FIG. 5, an angle α formed between any bottom surface 123 and the cutting surface 110 is less than 30°. That is, the angle α formed between the bottom surface 123 and a plane where the cutting surface 110 is located is less than 30°, which may be, for example, 25°, 20°, 15°, 10°, 5°, or 0°. If the angle α formed between the bottom surface 123 and the plane where the cutting surface 110 is located is smaller, the rectangular portion 111 has a smaller surface area, and the cutting surface 110 has a smaller surface area, thereby helping to reduce dangling bonds and recombination centers at the surface of the cutting surface 110, helping to reduce a recombination current at an edge of the segmented solar cell 100, and improving performance of the segmented solar cell 100.

FIG. 6 is a schematic diagram of a partial structure of another segmented solar cell according to some embodiments of the present disclosure.

In some embodiments, referring to FIG. 6, a depth H2 of any rectangular portion 111 recessed towards the segmented solar cell 100 ranges from 10 nm to 500 nm. The depth may be, for example, 10 nm, 60 nm, 110 nm, 120 nm, 150 nm, 170 nm, 210 nm, or 300 nm. In some other embodiments, the depth H2 of any rectangular portion 111 recessed towards the segmented solar cell 100 may be within the following ranges: 10 nm to 50 nm, 50 nm to 100 nm, 100 nm to 150 nm, 150 nm to 200 nm, 200 nm to 250 nm, 250 nm to 300 nm, 300 nm to 350 nm, 350 nm to 400 nm, 400 nm to 450 nm, or 450 nm to 500 nm. If the depth of the rectangular portion 111 recessed towards the segmented solar cell 100 is excessively large, the surface-to-plane ratio of the segmented solar cell 100 may be excessively large. That is, there may be more dangling bonds and recombination centers at the cutting surface 110 formed by cutting. Therefore, when the depth of the rectangular portion 111 recessed towards the segmented solar cell 100 is less than 500 nm, it is conducive to ensuring that the cutting surface 110 has fewer dangling bonds and recombination centers.

In some embodiments, referring to FIG. 6, along the direction perpendicular to the cutting surface 110, a height difference H1 is formed between the bottom surfaces 123 of two overlapping rectangular portions 111. It is to be noted that in a case where the bottom surfaces 123 of two overlapping rectangular portions 111 are not parallel to each other, the height difference between the bottom surfaces 123 of the two rectangular portions 111 refers to a height difference between a position where the bottom surface 123 of one rectangular portion 111 has the shallowest depth and a position where the bottom surface 123 of the other rectangular portion 111 has the shallowest depth.

In some embodiments, along the direction perpendicular to the cutting surface 110 (the second direction X), the height difference H1 between the bottom surfaces 123 of two overlapping rectangular portions 111 ranges from 10 nm to 500 nm. The height difference may be, for example, 10 nm, 60 nm, 110 nm, 120 nm, 150 nm, 170 nm, 210 nm, or 300 nm. In some embodiments, along the direction perpendicular to the cutting surface 110, the height difference H1 between the bottom surfaces 123 of two overlapping rectangular portions 111 may be within the following ranges: 10 nm to 50 nm, 50 nm to 100 nm, 100 nm to 150 nm, 150 nm to 200 nm, 200 nm to 250 nm, 250 nm to 300 nm, 300 nm to 350 nm, 350 nm to 400 nm, 400 nm to 450 nm, or 450 nm to 500 nm. If the height difference H1 between two overlapping rectangular portions 111 is excessively large, the surface-to-plane ratio of the segmented solar cell 100 may be excessively large. That is, the cutting surface 110 may have a larger surface area, thereby resulting in more dangling bonds and recombination centers at the cutting surface 110 formed by cutting. Therefore, when the height difference H1 between the bottom surfaces 123 of the two overlapping rectangular portions 111 is less than 500 nm, it is conducive to ensuring that the cutting surface 110 has fewer dangling bonds and recombination centers.

In some embodiments, referring to FIG. 4, the rectangular portion 111 includes a long side 120 and a wide side 121. A size of the long side 120 is defined as a first size, and a size of the wide side 121 is defined as a second size. A product of the first size and the second size is defined as a first value. For any rectangular portion 111, a ratio of an area value of the bottom surface 123 of the rectangular portion 111 to the first value is within a range from 10% to 90%, which may be, for example, 10%, 30%, 50%, 70%, or 90%. In some embodiments, for any rectangular portion 111, the ratio of the area value of the bottom surface 123 of the rectangular portion 111 to the first value may be within a range from 10% to 30%, a range from 30% to 50%, a range from 50% to 70%, or a range from 70% to 90%. The ratio of the area value of the bottom surface 123 of one rectangular portion 111 to the first value may represents a size of a part of the rectangular portion 111 not overlapping with other rectangular portion 111.

In some embodiments, the density of the rectangular portions 111 at the cutting surface 110 ranges from 10³ to 10⁵ /mm², from 10³ to 10⁴ /mm², or from 10⁴ to 10⁵ /mm², which may be, for example, 10³ /mm², 10⁴ /mm², or 10⁵ /mm². It is to be noted that the density of the rectangular portions 111 at the cutting surface 110 refers to a number of the rectangular portions 111 at the cutting surface 110 per unit area, and the unit area is 1 mm². If the density of the rectangular portions 111 at the cutting surface 110 is excessively high, the cutting surface 110 may have an excessively large surface area, thereby resulting in more dangling bonds and recombination centers at the cutting surface 110 formed by cutting. If the density of the rectangular portions 111 at the cutting surface 110 is excessively low, other structures with a greater degree of concavity and convexity at the cutting surface 110 may occupy an excessively large area, thereby resulting in more dangling bonds and recombination centers at the cutting surface 110 formed by cutting. Therefore, when the density of the rectangular portions 111 at the cutting surface 110 is within the above-mentioned range, it is conducive to ensuring that the number of the rectangular portions 111 at the cutting surface 110 is within a reasonable range, preventing an increase in the surface are of the cutting surface 110 caused by excessively dense or excessively sparse rectangular portions 111. Therefore, it is conducive to ensuring that the cutting surface 110 has fewer dangling bonds and recombination centers.

In some embodiments, referring to FIG. 4, the rectangular portion 111 includes a long side 120 and a wide side 121. Along an extension direction of the long side 120, a size L2 of the long side 120 ranges from 3 µm to 15 µm; and/or along an extension direction of the wide side 121, a size L1 of the wide side 121 ranges from 3 µm to 15 µm. In some examples, along the extension direction of the long side 120, the size L2 of the long side 120 may be 3 µm, 4 µm, 5 µm, 6 µm, 7 µm, or 11 µm. In some examples, along the extension direction of the wide side 121, the size L1 of the wide side 121 may be 3 µm, 4 µm, 5 µm, 6 µm, 7 µm, or 11 µm. In some embodiments, along the extension direction of the long side 120, the size L2 of the long side 120 may be within the following ranges: 3 µm to 6 µm, 6 µm to 9 µm, 9 µm to 12 µm, or 12 µm to 15 µm. In some embodiments, along the extension direction of the wide side 121, the size L1 of the wide side 121 may be within the following ranges: 3 µm to 6 µm, 6 µm to 9 µm, 9 µm to 12 µm, or 12 µm to 15 µm.

Compared with a case where the cutting surface 110 includes more irregular protruding structures or concave structures, and the protruding structures protrude obviously and the concave structures are recessed deeply, in some embodiments of the present disclosure, the use of the rectangular portions 111 as the structures at the cutting surface 110 helps to reduce a surface-to-plane ratio of the segmented solar cell 100, that is, helps to improve flatness of the cutting surface 110 of the segmented solar cell 100 formed by cutting, so that the cutting surface 110 formed by cutting has a smaller surface area, thereby reducing dangling bonds and recombination centers at the surface of the cutting surface 110, helping to reduce a recombination current at an edge of the segmented solar cell 100, and improving performance of the segmented solar cell 100.

Correspondingly, in another aspect, some embodiments of the present disclosure further provide a method for forming a segmented solar cell, which may be used to form the segmented solar cell provided in the above-described embodiments. It is to be noted that for parts that are the same as or corresponding to the foregoing embodiments, please refer to the detailed description of the foregoing embodiments. Details are not described below.

The method for forming the segmented solar cell 100 includes: providing a solar cell; and cutting the solar cell to form the segmented solar cell 100 including a cutting surface 110 formed by cutting, at least part of the cutting surface 110 including a first texture structure, the first texture structure including at least a plurality of polygonal portions 111, and at least one of the polygonal portions 111 partially overlapping with at least one neighboring polygonal portion of the polygonal portions 111.

In some embodiments, the cutting includes: laser-grooving the solar cell by using a laser grooving process to form a groove at part of a surface of the solar cell, and for the laser grooving process, a laser wavelength ranges from 500 nm to 1000 nm, which may be, for example, 500 nm, 600 nm, 700 nm, 800 nm, or 900 nm. In some embodiments, for the laser grooving process, the laser wavelength may be within the following ranges: 500 nm to 600 nm, 600 nm to 700 nm, 700 nm to 800 nm, or 800 nm to 900 nm.

In some embodiments, for the laser grooving process, a laser pulse width ranges from 10 ns to 1000 ns, which may be, for example, 10 ns, 100 ns, 200 ns, 300 ns, 500 ns, or 800 ns. In some embodiments, for the laser grooving process, the laser pulse width may be within the following ranges: 10 ns to 200 ns, 200 ns to 400 ns, 400 ns to 600 ns, 600 ns to 800 ns, or 800 ns to 1000 ns.

In some embodiments, for the laser grooving process, laser power ranges from 50 W to 100 W, which may be, for example, 50 W, 60 W, 70 W, 80 W, or 90 W. In some embodiments, for the laser grooving process, the laser power may be within the following ranges: 50 W to 60 W, 60 W to 70 W, 70 W to 80 W, 80 W to 90 W, or 90 W to 100 W.

A groove configured to segment the solar cell is formed at the solar cell by using laser grooving, and then the solar cell is broken off from the groove, to obtain the segmented solar cell 100.

In some embodiments, the cutting further includes: heating the groove by using a laser heating process. The groove is locally heated by the laser heating process, making it easier to make the solar cell be broken off from the groove.

In some embodiments, for the laser heating process, a laser wavelength ranges from 500 nm to 1000 nm, which may be, for example, 500 nm, 600 nm, 700 nm, 800 nm, or 900 nm. In some embodiments, for the laser heating process, the laser wavelength may be within the following ranges: 500 nm to 600 nm, 600 nm to 700 nm, 700 nm to 800 nm, or 800 nm to 900 nm.

In some embodiments, for the laser heating process, a laser pulse width ranges from 10 ns to 1000 ns, which may be, for example, 10 ns, 100 ns, 200 ns, 300 ns, 500 ns, or 800 ns. In some embodiments, for the laser heating process, the laser pulse width may be within the following ranges: 10 ns to 200 ns, 200 ns to 400 ns, 400 ns to 600 ns, 600 ns to 800 ns, or 800 ns to 1000 ns.

In some embodiments, for the laser heating process, laser power ranges from 20 W to 50 W. The laser power may be, for example, 20 W, 25 W, 30 W, 35 W, or 45 W. In some embodiments, for the laser heating process, the laser power may be within the following ranges: 20 W to 30 W, 30 W to 40 W, or 40 W to 50W.

For the segmented solar cell obtained by using the method for forming a segmented solar cell provided in the above-described embodiments, the surface structure at the cutting surface includes polygonal portions, so that the segmented solar cell has a smaller surface-to-plane ratio, the cutting surface has higher flatness, and the cutting surface has a smaller surface area, thereby helping to reduce dangling bonds and recombination centers at the surface of the cutting surface, helping to reduce a recombination current at an edge of the segmented solar cell, and improving performance of the segmented solar cell.

Correspondingly, some embodiments of the present disclosure further provide a photovoltaic module, including: a solar cell string, the solar cell string including the segmented solar cell according to any one of the above-described embodiments; an encapsulation adhesive film configured to cover a surface of the solar cell string; and a cover plate configured to cover a surface of the encapsulation adhesive film away from the solar cell string.

In some embodiments, adjacent segmented solar cells are connected together by a connecting member, the connecting member is located at a surface of a busbar in the segmented solar cell away from a solar cell body and in electrical contact with the busbar. An end of the connecting member is electrically connected to a busbar of one segmented solar cell, and another end of the connecting member is electrically connected to a busbar of the other segmented solar cell. The connecting member may be soldered to a soldering portion of the busbar, so that the connecting member is electrically connected to the busbar and a plurality of segmented solar cells are connected in series by the connecting members.

The connecting member may be formed by a conductive layer and a soldering layer wrapping a surface of the conductive layer. A material of the conductive layer includes a conductive material with good conductivity such as copper, nickel, gold, or silver, or an alloy material with low resistivity. A material of the soldering layer includes a material with lower melting points such as tin-zinc alloy, tin-bismuth alloy, or tin-indium alloy.

In some embodiments, there may be flux in the soldering layer. The flux refers to a chemical substance that can help and facilitate the soldering in a soldering process, and also has a protective effect and prevents oxidation reactions. Since a melting point of the flux is lower than a melting point of the soldering layer, the flux can help increase fluidity of a molten soldering layer so that the connecting member and a busbar structure can be better alloyed. In some embodiments, the flux includes inorganic flux, organic flux, and resin flux.

In some embodiments, the encapsulation adhesive film may be an organic encapsulation adhesive film such as an ethylene-vinyl acetate copolymer adhesive film, a polyethylene octene co-elastomer adhesive film, or a polyvinyl butyral ester adhesive film. On the one hand, the encapsulation adhesive film can prevent damage to the photovoltaic cell due to harsh environments (such as rain, snow, sand, dust, and heat), improve durability of the photovoltaic cell, and prolong the service life of the photovoltaic cell. On the other hand, the encapsulation adhesive film can also prevent formation of an oxide layer at the surface of the photovoltaic cell to ensure highest efficiency of power conversion.

In some embodiments, the cover plate may be a glass cover plate, a plastic cover plate, or another cover plate with a light-transmitting function. The cover plate can prevent an influence of the environment on the photovoltaic cell and prolong the service life and improve stability of the photovoltaic module.

Those of ordinary skill in the art may understand that the above embodiments are specific embodiments of implementation of the present disclosure, and in practical application, may be varied in form and detail without departing from the scope of the present disclosure. Any person skilled in the art may make respective changes and modifications without departing from the scope of the present disclosure. Therefore, the protection scope of the present disclosure shall be subject to the scope defined by the claims.

## Claims

1. A segmented solar cell (100), comprising:
a substrate (11) having a first surface and a second surface opposite to the first surface;
a passivation layer formed over the first surface; and
at least one electrode formed over the passivation layer;
wherein the substrate (11) has a cutting surface (110) formed by cutting a solar cell, the cutting surface (110) connecting the first surface and the second surface;
wherein at least part of the cutting surface (110) comprises a first texture structure, the first texture structure comprises polygonal portions (111), and at least one polygonal portion of the polygonal portions (111) partially overlaps with at least one neighboring polygonal portion of the polygonal portions (111).

2. The segmented solar cell (100) according to claim 1, wherein the polygonal portions (111) are recessed towards the segmented solar cell (100).

3. The segmented solar cell (100) according to claim 2, wherein a depth of at least some of the polygonal portions (111) recessed towards the segmented solar cell (100) ranges from 10 nm to 500 nm.

4. The segmented solar cell (100) according to claim 2 or claim 3, wherein a bottom surface of at least one of the polygonal portions (111) is a planar surface.

5. The segmented solar cell (100) according to claim 4, wherein an angle formed between the bottom surface of the at least one of the polygonal portions (111) and the cutting surface (110) is less than 30°.

6. The segmented solar cell (100) according to claim 4 or claim 5, wherein along a direction perpendicular to the cutting surface (110), a height difference is formed between the bottom surfaces of two polygonal portions (111) that overlap with each other.

7. The segmented solar cell (100) according to claim 6, wherein along the direction perpendicular to the cutting surface (110), the height difference formed between the bottom surfaces of the two polygonal portions (111) that overlap with each other is within a range from 10 nm to 500 nm.

8. The segmented solar cell (100) according to any one of claims 1 to 7, wherein any of the polygonal portions (111) is adjacent to at least one neighboring polygonal portion of the polygonal portions (111), and any of the polygonal portions (111) partially overlaps with the at least one neighboring polygonal portion of the polygonal portions (111).

9. The segmented solar cell (100) according to claim 8, wherein the polygonal portions (111) are implemented as rectangular portions, the rectangular portions each comprise a long side and a wide side, a size of the long side is defined as a first size, a size of the wide side is defined as a second size, a product of the first size and the second size is defined as a first value, and for any of the rectangular portions, a ratio of an area value of the bottom surface of the rectangular portion to the first value is within a range from 10% to 90%.

10. The segmented solar cell (100) according to any one of claims 1 to 9, wherein a density of the polygonal portions (111) located at the cutting surface (110) is within a range from 10³ to 10⁵/mm².

11. The segmented solar cell (100) according to any one of claims 1 to 7, wherein the polygonal portions (111) are implemented as rectangular portions, the rectangular portions each comprise a long side and a wide side; and along an extension direction of the long side, a size of the long side is within a range from 3 µm to 15 µm, and/or along an extension direction of the wide side, a size of the wide side is within a range from 3 µm to 15 µm.

12. A photovoltaic module, comprising:
a solar cell string comprising the segmented solar cell (100) according to any one of claims 1 to 11;
an encapsulation adhesive film configured to cover a surface of the solar cell string; and
a cover plate configured to cover a surface of the encapsulation adhesive film away from the solar cell string.

13. The photovoltaic module according to claim 12, wherein the encapsulation adhesive film is an organic encapsulation adhesive film.

14. The photovoltaic module according to claim 13, wherein the organic encapsulation adhesive film includes an ethylene-vinyl acetate copolymer adhesive film, a polyethylene octene co-elastomer adhesive film, or a polyvinyl butyral ester adhesive film.

15. The photovoltaic module according to any one of claims 12 to 14, wherein the cover plate is a light-transmitting cover plate including a glass cover plate or a plastic cover plate.
